# EUROPEAN PATENT SPECIFICATION

(11) **EP 0 703 859 B1**
(45) Date of publication and mention of the grant of the patent: **01.10.1997**
(21) Application number: 94916474.3
(22) Date of filing: 11.05.1994
(51) Int. Cl.: B41F 15/36, B41F 15/20, B41F 15/08

(54) **CLAMPING-STRETCHING SYSTEM FOR STENCILS FOR SCREEN PRINTERS, WITH PRINTING TABLE FOR PC BOARDS**
KLEMM- UND SPANNSYSTEM FÜR SCHABLONEN FÜR SIEBDRUCKMASCHINEN MIT DRUCKTISCH FÜR GEDRUCKTE LEITERPLATTEN
SYSTEME DE SERRAGE-VERROUILLAGE DE POCHOIRS POUR INSTALLATIONS D'IMPRESSION AU CADRE, MUNI D'UN PLATEAU D'IMPRESSION DE CARTES DE CIRCUITS IMPRIMES

(30) Priority: 12.05.1993 SI 9300252
(43) Date of publication of application: 03.04.1996
(73) Proprietor: ZELTRA, PODJETJE ZA PROJEKTIRANJE, PROIZVODNJO IN TRGOVINO ELEKTROTEHNIKE, NAKLO, D.O.O., 642 02 Naklo (SI)
(72) Inventor: ZEPIC, Janez, 611 13 Ljubljana (SI); STUPAR, Joze, 683 61 Dvor Pri Zuzemberku (SI); VIZJAK, Kilijan, 640 00 Kranj (SI)
(74) Representative: Braun, Dieter, Dipl.-Ing. Patentanwälte, Hagemann & Kehl
(86) International application number: SI9400006
(87) International publication number: WO9426518

(56) References cited:
- DE-U- 9 108 120
- US-A- 3 172 358
- US-A- 3 485 165
- US-A- 3 486 441

## Description

The invention relates to a clamping-stretching system for stencils for all types of screen printers, also for machines with a universal printing table, the latter being the subject of this invention, too. The clamping-stretching system for stencils for screen printers, with a printing table for PC boards is intended for applying colours, pastes, adhesives, etc. onto even surfaces of an print, and for through plating, preferably of electronic printed circuit boards.

The technical problem solved by the invention is universal, simple and at the same time precise clamping of stencils and in conjunction with a machine which, in addition to applying colours, pastes, adhesives, etc., onto the even surfaces of prints via a stencil, also makes it possible to apply preferably pastes into the holes of prints, and thereby, in the case of electronic PC boards, through plating.

The usual way of applying colours, pastes, adhesives, etc. is by screen printing technique. In this technique, a screen is fixed into a frame, the frame is clamped into a machine, and the machine approaches the frame to the print, while a squeegee presses the screen against the print and applies colour, paste, adhesive, etc. over the screen. Each screen is clamped into its own frame and shall not be removed from it. Each screen therefore requires its own frame, which is expensive and impractical for storage. Metal stencils or stencils made from synthetic materials have been used more recently, although the clamping into the frame in accordance with the prior art is similar as with the screen printing technique. A screen is clamped into a frame, and a stencil is fixed onto the screen. There are several drawbacks to such a solution: problems with storing stencils together with the frames, stencils are difficult to clean, the stretching of screens is complicated, mechanical sensitivity, and no possibility to adjust the tension of a stencil. Another known solution is that with a stencil clamping device, where on the one side the stencil is clamped into the frame, and on the other into a mobile bar, whose motion and thereby stretching of the stencil is pneumatic. Such a solution is complicated and it requires a great number of frames for various types of machines. A solution of a clamping-stretching system for stencils with a machine which, in addition to applying colours, pastes, adhesives, etc. onto the even surfaces of prints, would also make it possible to apply preferably pastes into the holes of an print, has not been known, or has not been known to the applicant.

From US 3,485,165 a clamping-stretching system is already known, where stencils are clamped onto frame in exchangable manner. The marginal edge portions of the screen are looped back upon themselves, and these loops are inserted into grooves of the crossbars. Then anchor pins are inserted through the loops, and the pins lock the marginal edge portions of the screen to the crossbars, when these crossbars are retracted relative to all four frame sides.

Suction stenciling apparatus as described in US 3,172,358 is intended for multi-color printing of porous sheet material. Reduced pressure is provided to held the sheet material in place over the convex supporting means and to obtain fluid-tight space between stencil and said porous sheet material.

The invention as claimed is intended to remedy the drawbacks of stencil clamping and to ensure simple and fast clamping of various stencils into the same frame, whereby an easy and effective adjustment of its tension should be ensured along its entire width and therewith its harmless clamping, i.e. clamping without distortions, whereby the frame with the clamping system will be applicable for all types of machines in the screen printing or stencil printing technology, and it should additionally make it possible to apply preferably pastes into the holes of an print.

This is achieved through a clamping-stretching system for stencils for screen printers, preferably for machines with a universal printing table for PC boards, according to the main patent claim.

The essential advantage of the invention as claimed is that it allows simple, fast and unambiguous clamping of different stencils of different sizes into the same universal frame, whereby easy and effective adjustment of its tension should be ensured along its entire width, and thereby its harmless clamping, i.e. clamping without distortions, and additionally the application of preferably pastes into the holes of the print will be additionally made possible.

The invention is described in drawings which illustrate several embodiments, in which:
Figure 1 is a front view of a screen printer in position for application.
Figure 2 is a side view of a screen printer in open position.
Figure 3 is a cross-section of a machine with an embodiment of a clamping-stretching system for stencils, with a printing table for PC boards.
Figure 4 is a cross-section of an embodiment of clamping - stretching system.
Figure 5 is a floor plan of an embodiment of clamping - stretching system.
Figure 6 is a cross-section of details of guiding and fixing crossbars.
Figure 7 is a cross-section of the first embodiment of clamping a stencil into a clamping - stretching system.
Figure 8 is a cross-section of a stencil according to the first embodiment of stencil.
Figure 9 is an illustration of the second embodiment of a clamping-stretching system.
Figure 10 is a plan according to the second embodiment of a stencil
Figure 11 is a cross-section of an embodiment of a printing table with spacers
Figure 12 is a plan of an embodiment of printing table with spacers.

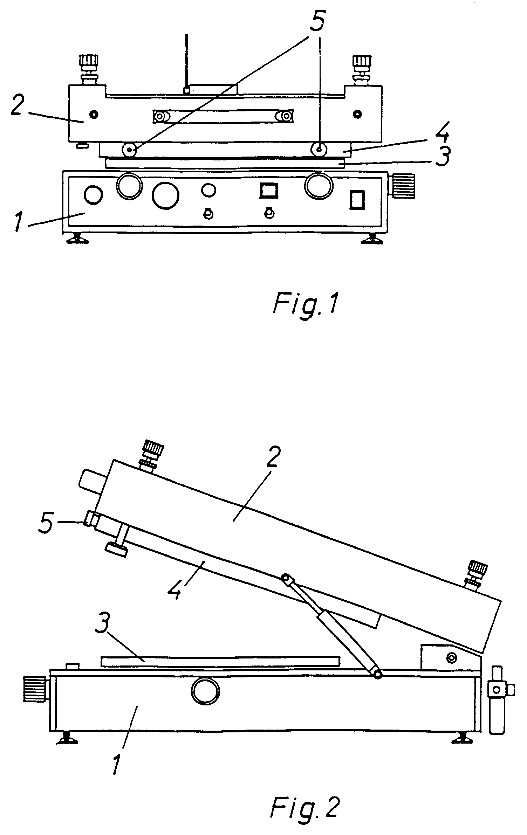

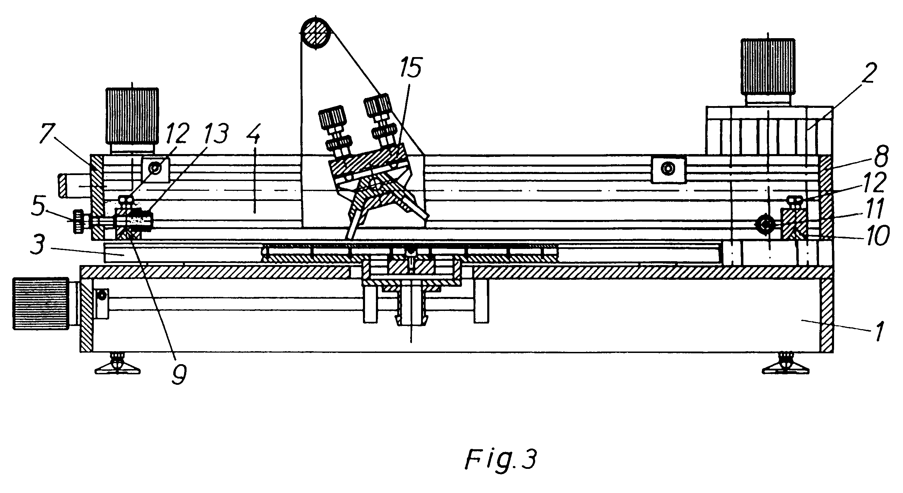

A printer for the production of PC boards of the screen printing machine type with a stencil with angle opening system, serving as an embodiment of the invention, together with an embodiment of the invention of a clamping-stretching system for stencils, with a printing table for PC boards according to Figures 1, 2 and 3, include a bottom part 1 and a top 2 being linked by bearings on the rear side in such a manner that the top 2 opens upward and in this way the introduction and withdrawal of prints is possible. On the bottom part 1 there is a printing table 3 which is designed universally for different print sizes, different application procedures as well as different shifts, either longitudinal, transversal or rotational. The clamping of prints for the application of preferably pastes into the holes of prints is carried out with vacuum. The fixation of the printing table 3 to the bottom part 1 as well as the connection to the vacuum pump are carried out centrically. At the nether side of the top 2 there is a frame 4 of the clamping-stretching system for stencils, which is according to the first embodiment illustrated in Figure 3, a component part of its structure, while in the second embodiment it is fixed to it in such a way that it can be removed.

The frame 4 of the clamping-stretching system for stencils according to the first embodiment illustrated in Figure 3 consists of two side profiles 6 with grooves in which a front crossbar 9 and a back crossbar 10 are guided. The side profiles 6 are according to this embodiment of invention the elements of the top 2 of the printer and they are fixed to the front wall 7 and the back wall 8 of the top 2. The motion of the back bar 10 is limited by two adjustable screws 11 in the grooves of the side profiles 6, while the movement of the front bar 9 is limited by at least one regulation system made up of an adjustment screw 5 and a cascade of disk springs 13. The adjustment screw 5 rests at the one side against the front wall 7 and at the other via the cascade of disk springs 13 against the bar 9. Onto the bar 9 a stencil 14 is fixed by means of screws 12 in such a way as it will be described further on. Through the adjustment screw 5 the required tension of the stencil 14 is achieved. The top 2 is open from the upper side, so that the stencil 14 and through it the print on the table 3 can be seen, whereby a precise positioning of the table 4 with the print with regard to the stencil 14 is made possible. By means of a squeegee 15 colour, paste, adhesive, etc., is applied via the stencil 14 to the print.

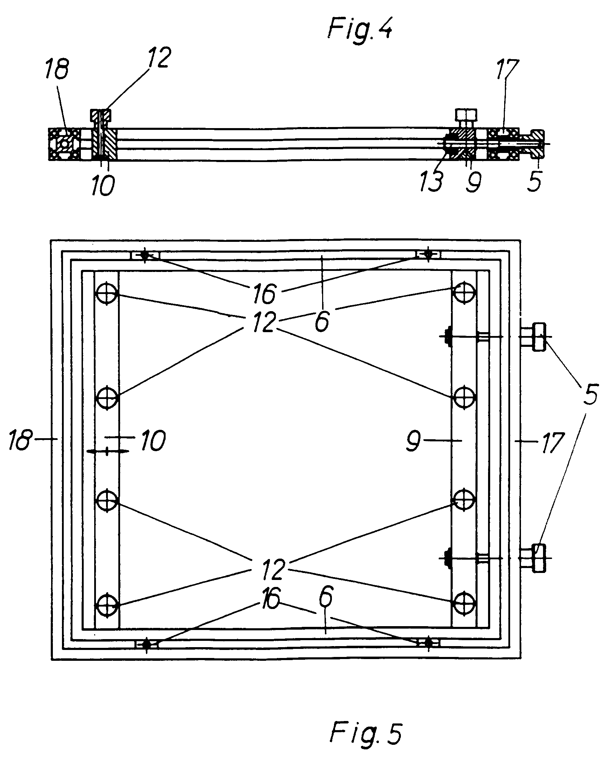

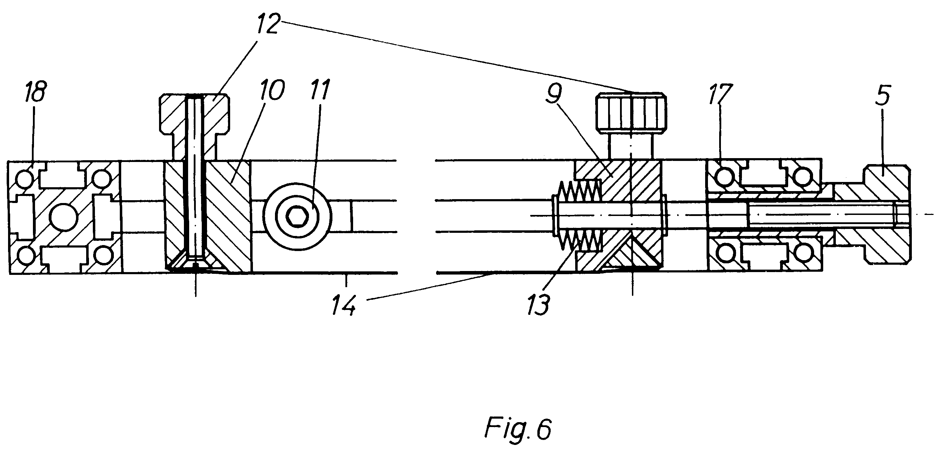

The frame 4 of the clamping-stretching system for stencils according to the second embodiment illustrated in Figures 4 and 5 is intended for removable fixation onto the nether side of the top 2. The frame 4 consists of two side profiles 6 which are fixedly joined with a front profile 17 and a back profile 18. As it is illustrated in Figure 6, the two side profiles 6 have grooves in which the front crossbar 9 and the back crossbar 10 are guided. Both crossbars 9 and 10 serve for the clamping of the stencil. The movement of the back bar 10 is limited by two adjustable screws 11 in the grooves of the side profiles 6, while the movement of the front bar 9 is limited by at least one regulation system made up of an adjustment screw 5 and a cascade of disk springs 13. The adjustment screw 5 rests at the one side against the front profile 17, and at the other side via the cascade of disk springs 13 against the bar 9. A stencil 14 is fixed to the bars 9 and 10 by means of screws 12 in such a way as it will be described further on. By the regulation system the required tension of the stencil 14 is achieved. According to this embodiment of the invention, the frame 4 of the stencil is fixed in a removable way onto the nether side of the top 2, preferably by means of screws onto nuts 16, which are movable alongside the grooves of the side profiles 6.

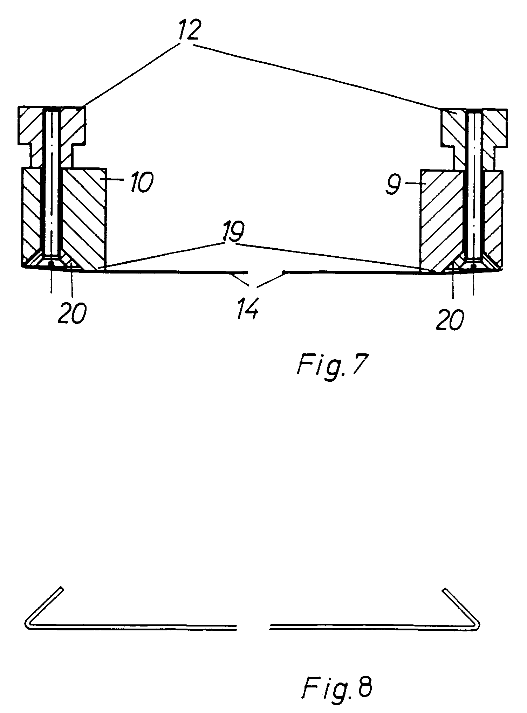

The clamping of the stencil 14 between the front crossbar 9 and the back crossbar 10 according to the first embodiment of the invention with details illustrated in Figure 7 is carried out in such a way that the stencil 14, which is shown as a detail in cross-section in Figure 8, is fitted behind a three-sided pressure bar 20. Two three-sided pressure bars 20 fit along their entire length into correspondingly three-sided grooves along the entire length of the crossbars 9 and 10, being fixed to these bars into the grooves by means of at least two screws 12. The crossbars 9 and 10 according to this embodiment of the invention have along the entire length of their nether inner side an embossed front 19, which makes it possible to precisely position the stencil 14. When the stencil 14 is fitted behind the two three-sided pressure bars 20, the screws 12 are tightened whereby the stencil 14 is fixed. In this embodiment of the invention the stencil 14 has its two transversal edges bent into an acute angle equal to the corresponding angle of the three-sided pressure bar 20, which is preferably 40 - 50 degrees.

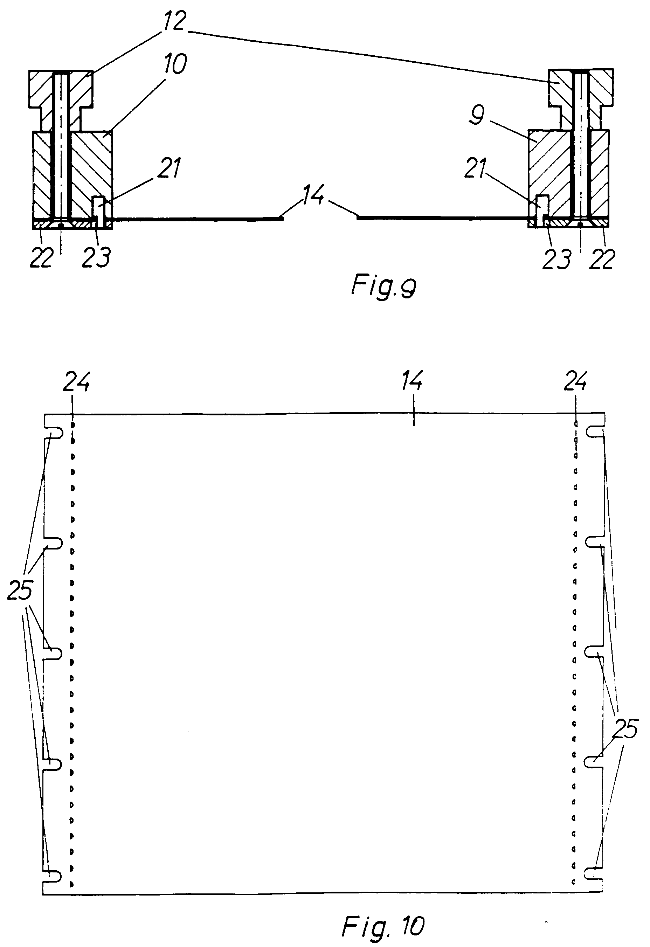

The clamping of the stencil 14 between the front crossbar 9 and the back crossbar 10 according to the second embodiment of the invention with details illustrated in Figure 9 is carried out in such a way that the stencil 14, which is illustrated as a detail in Figure 10, is fitted onto pins 21. Rectangular pressure bars 22 are fitted with holes or perforation 24 which correspond to the pins 21 and they fit along their entire length onto the crossbars 9 and 10 being fixed to them by at least two screws 12. According to this embodiment, the crossbars 9 and 10 have at the nether inner side, in their longitudinal direction evenly arranged inserted pins 21, whose cross-section has, in the part jutting out of the crossbars 9 and 10, the shape of an approximate semicircle, with their rounded end turned towards the transversal symmetral of the stencil 14. The stencil 14, which is illustrated in this embodiment in Figure 10, has on its transversal edges guides 25 in the form of U-shaped notches made in such a way that the notches agree with the screws 12. Through an asymmetrical arrangement of the guides 25 a correct and unambiguous insertion of stencils is ensured. The stencil 14 is also fitted, along its transversal edges, with the perforation 24, the arrangement and the form of the perforation 24 fitting the arrangement and form of the pins 21. When the screws 12 are released, the pressure bars 22 move away from the crossbars 9 and 10, and the stencil 14 is by means of the guides 25 positioned so that its perforation 24 fits onto the pins 21. Then the screws 12 are tightened and the stencil 14 is fixed.

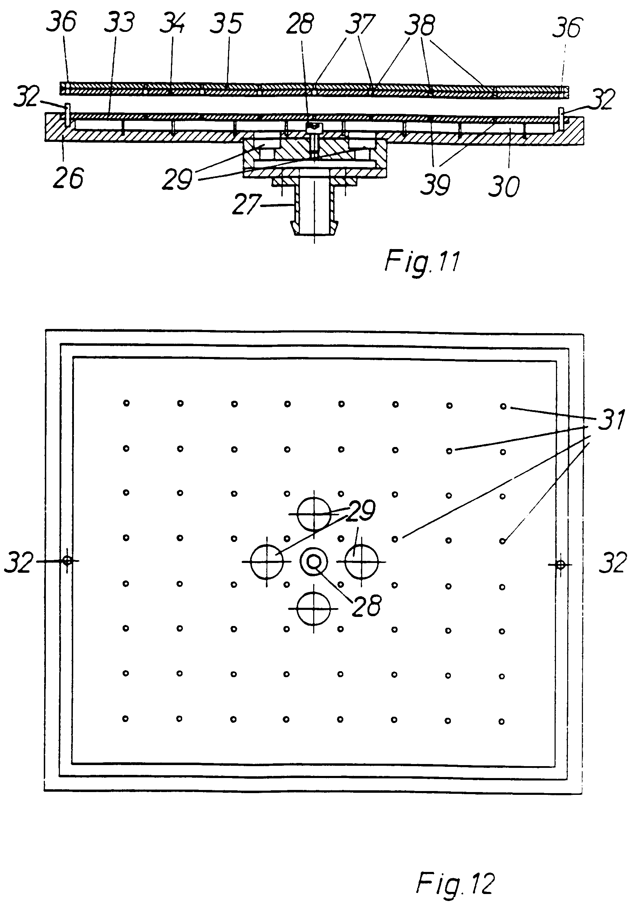

A printing table 3, an embodiment of which is illustrated in Figures 11 and 12, has, fixed to its body 26 with a screw 28, a vacuum connection. Through openings 29, which are centrically arranged around the screw 28, vacuum is evenly dispersed inside a vacuum chamber 30. The vacuum chamber 30 is made up of the body 26 of the table 3 and a reception plate 33 which is placed on the body 26 in a removable manner. Accurate positioning of the plate 33 onto the table 3 is assisted by two exchangeable or, if necessary, removable pins 32 at the opposite edges of the table 3 and two corresponding bore-holes 36 on the plate 33. In order to protect the plate 33 from distortion by vacuum in the chamber 3, this is supported by spacers 31. The spacers 31 are of preferably circular cross-section and they are inserted into the corresponding bore-holes in the body 26 in such a way that they can be pulled out or, if necessary, removed. As it is illustrated in Figure 12, the spacers 31 form a regular pattern. The length of the spacers 31 is such that the tips of the spacers 31 inserted into the bore-holes of the body 26 reach exactly to the edge of the body 26, onto which the plate 33 is laid. In the case when the printing table 3 serves for applying pastes for through plating of PC boards, the bore-holes 39 on the reception plate 33 are arranged exactly the same as the holes 37 on the print 35 which is to be through-plated, their diameter being, however, slightly bigger. When a larger series of prints is to be through-plated, an intermediate plate is inserted between the print 35 and the plate 33, the bore-holes 38 of which are arranged exactly in the same manner as the holes 37 on the print 35 which is to be through-plated, their diameter being still slightly larger than that of the bore-holes 39 on the plate 33. The bore-holes 38 are intended for depositing excess paste that was sucked by vacuum in the chamber 30 through the holes 37 of the print 35. This makes it possible to apply the paste on a larger quantity of prints without having to clean or remove the paste from the bore-holes 38 and 39. For smaller quantities of prints the intermediate plate 34 is not necessary. The size ratio between the holes 37, the bore-holes 39 and the bore-holes 38 is important, among other because paste has to be applied both on the walls of the holes 37 and on the vicinity of the holes 37 on the nether surface of the print 35, which ensures proper electrical contact. The print 35 and, if necessary, the intermediate plate 34 are laid and positioned on the table 3 in such a way that the two pins 32 fit into the bore-holes 36. The reception plate 33, the print 35 and, it necessary, the intermediate plate 34 are positioned so that the centres of the boles 37 and those of the bore-holes 39 and 38 correspond. Of course, also other bore-holes on the stencil 14 have to correspond to these centres, which is achieved by shifting the table 3. In order to assure a normal course of through-plating procedure of the holes 37, the holes 37 and all the corresponding bore-holes have to allow a free passage to vacuum which sucks the paste applied with a squeegee 15 onto the stencil 14 into the holes 37. As the arrangement of the spacers 31 is predetermined with the corresponding bore-holes in the body 26, it may happen that one of the spacers 31 would get stuck in one of the bore-holes 39 and in this way disturb the action of vacuum. For such a case it is important that the spacers 31 be inserted into the body 26 in such a manner that they can be pulled out at any time, as described before.

It is understood that the plate 33 is exchangeable and with its arrangement of bore-holes adaptable to different PC boards. In addition it is understood that, for some types of applications, the plate 33 has no bore-holes 39 and that no vacuum is required in the vacuum chamber 30, and that in this case prints are positioned only with the pins 32, or in some other known way, and that also the fixing of prints is carried out in some other known way.

The procedure of applying colours, pastes, adhesives, etc. runs as follows: that the stencil 14 is clamped with the screws 12 between the back crossbar 10 and the front crossbar 9, the back crossbar 10 is fixed with screws 11 to side profiles 6, and with one or several adjustment screws 5 the stencil is stretched and straightened. An adequate reception plate 33 is laid on the table 3 which adequately regulates vacuum and airflow, and its duration. If necessary, an intermediate plate 34 is placed on the plate 33, and then the print 35. The top 2 is set onto bottom part 1 with which the stencil 14 is approached to the print 35. Then colour, paste or adhesive is applied with the squeegee 15. In the case of applying paste for through-plating PC boards, vacuum sucks up the paste and applies it onto the walls of the holes 37, as well as onto its vicinity at the nether surface of the print 35. To the vicinity of the hole 37 on the upper surface of the print 35, the paste is applied directly with the squeegee 15 across the stencil 14.

## Claims

1. A clamping-stretching system for stencils for screen printers, with a printing table for PC boards, where colours, pastes, adhesives, etc. are applied via a stencil onto items, having front crossbar and back crossbar guided In side profiles of a frame characterized in that said front crossbar (9) and said back crossbar (10) have in their nether side fastening means and a pressure bar (20, 22) which presses a stencil (14) against said crossbar (9, 10) and that said front crossbar (9) rests via at least one adjustment screw (5) and a cascade of disk springs (13) against the front wall (7) and/or the front profile (17) of a frame, and that said table (3) has a vaccum connection (27) and comprises a vaccum chamber (30) made of the body (26) of said table (3) and a reception plate (33), wherein said reception plate (33) is supported by removable spacers (31) and that said table (3) has boreholes into which spacers (31) are inserted.

2. A clemping-stretching system for stencils for screen printers, with a printing table for PC boards as claimed in claim 1, characterized in that the stencil (14) fastening means comprises said front crossbar (9) and said back crossbar (10) having at the nether inner side along the entire length an embossed front (19) and a three-sided groove and that a three-sided pressure bar (20) is fixed with at least two screws (12) into the groove on said crossbar (9, 10), whereby the edges of the stencil (14) are bent at a same angle as the edge of said crossbar (9, 10), preferably 40 - 50 degrees.

3. A clamping-stretching system for stencils for screen printers, with a printing table for PC boards as claimed in claim 1, characterized in that the stencil (14) fastening means comprises said front crossbar (9) and said back crossbar (10) having at the nether inner side along the entire longitudinal direction evenly arranged inserted pins (21) which are in the part that juts out of said crossbar (9, 10) in cross-section shaped approximately as a semicircle, with their rounded end turned towards the transversal symmetral of the stencil (14), and that rectangular pressure bars (22) have holes along their length and the stencil (14) has perforation (24) along its edges which correspond to the arrangement of the pins (21) on said crossbars (9, 10), and that the stencil (14) has additional guides (25) at its edges in the form of U-shaped notches.

## Patentansprüche

1. Klemm-Spannsystem für Schablonen für Siebdruckmaschinen, mit einem Drucktisch für Leiterplatten, auf dem Farben, Kleister, Klebstoffe, etc. mittels einer Schablone auf Gegenstände aufgetragen werden, wobei das System eine vordere Querstange und eine hintere Querstange aufweist, die in Seitenprofilen eines Rahmens geführt werden, dadurch gekennzeichnet, daß die vordere Querstange (9) und die hintere Querstange (10) in ihrer Unterseite Befestigungsmittel und eine Druckstange (20, 22) aufweisen, die eine Schablone (14) gegen die Querstange (9, 10) preßt, und daß die vordere Querstange (9) mittels wenigstens einer Justierschraube (5) und einer Kaskade von Tellerfedern (13) gegen die Vorderwand (7) und/oder das Vorderprofil (17) eines Rahmens anliegt und daß der Drucktisch (3) einen Vakuumanschluß (27) besitzt und eine Vakuumkammer (30) aufweist, die aus dem Rumpf (26) des Tisches (3) und einer Aufnahmeplatte (33) gebildet ist, wobei die Aufnahmeplatte (33) durch entfernbare Abstandshalter (31) gestützt wird, und daß der Tisch (3) Bohrungen aufweist, in die Abstandshalter (31) eingesetzt sind.

2. Klemm-Spannsystem für Schablonen für Siebdruckmaschinen, mit einem Drucktisch für Leiterplatten, nach Anspruch 1, dadurch gekennzeichnet, daß die Befestigungsmittel für die Schablone (14) die vordere Querstange (9) und die hintere Querstange (10) aufweisen, die innen an der Unterseite entlang der gesamten Länge eine geprägte Front (19) und eine dreiseitige Nut aufweisen, und daß eine dreiseitige Druckstange (20) mit wenigstens zwei Schrauben (12) in der Nut auf der Querstange (9, 10) befestigt ist, wobei die Ränder der Schablone (14) in einem selben Winkel wie der Rand der Querstange (9, 10) gebogen sind, vorzugsweise 40 - 50 Grad.

3. Klemm-Spannsystem für Schablonen für Siebdruckmaschinen, mit einem Drucktisch für Leiterplatten, nach Anspruch 1, dadurch gekennzeichnet, daß die Befestigungsmittel für die Schablone (14) die vordere Querstange (9) und die hintere Querstange (10) aufweisen, die innen an der Unterseite entlang der gesamten Längsrichtung gleichmäßig angeordnete eingesetzte Stifte (21) aufweisen, die in dem Teil, der aus der Querstange (9, 10) hervorragt, im Querschnitt ungefähr halbkreisförmig sind, wobei ihre gerundeten Enden zu der querverlaufenden Symmetrielinie der Schablone (14) gedreht sind, und daß rechteckige Druckstangen (22) Löcher entlang ihrer Länge aufweisen und die Schablone (14) eine Perforation (24) entlang ihrer Ränder hat, die der Anordnung der Stifte (21) auf den Querstangen (9, 10) entsprechen, und daß die Schablone (14) zusätzliche Führungen (25) an ihren Rändern in der Form U-förmiger Ausnehmungen hat.

## Revendications

1. Système de bridage-tensionnage de pochoirs pour des appareils de sérigraphie, comportant un plateau d'impression pour des plaquettes à circuits imprimés où des couleurs, des pâtes, des adhésifs, etc. sont appliqués par l'intermédiaire d'un pochoir sur des pièces, comportant une traverse avant et une traverse arrière guidées dans des profilés latéraux d'un cadre, caractérisé en ce que ladite traverse avant (9) et ladite traverse arrière (10) comportent, dans leur côté inférieur, des moyens de fixation et une barre de pression (20, 22) qui presse un pochoir (14) contre ladite traverse (9, 10) et en ce que ladite traverse (9) repose par l'intermédiaire d'au moins une vis de réglage (5) et d'un empilage de disques à ressort (13) contre la paroi avant (7) et/ou le profilé avant (17) d'un cadre, et en ce que ledit plateau (3) comporte un raccord à vide (27) et présente une chambre à vide (30) formée du corps (26) dudit plateau (3) et d'une plaque (33) de réception, ladite plaque (33) de réception étant supportée par des entretoises amovibles (31) et en ce que ledit plateau (3) présente des trous dans lesquels pénètrent les entretoises (31).

2. Système de bridage-tensionnage des pochoirs pour des appareils de sérigraphie, ayant un plateau d'impression pour des plaquettes à circuits imprimés selon la revendication 1, caractérisé en ce que les moyens de fixation du pochoir (14) comprennent ladite traverse avant (9) et ladite traverse arrière (10) ayant, au côté inférieur et intérieur, sur toute la longueur, une face à empreinte (19) et une gorge à trois côtés et en ce qu'une barre (20) de pression à trois côtés est fixée avec au moins deux vis (12) dans la gorge sur ladite barre transversale (9, 10), grâce à quoi les bords du pochoir (14) sont pliés à un même angle que le bord de ladite traverse (9, 10), avantageusement de 40-50 degrés.

3. Système de bridage-tensionnage des pochoirs pour des appareils de sérigraphie, ayant un plateau d'impression pour des plaquettes à circuits imprimés selon la revendication 1, caractérisé en ce que les moyens de fixation du pochoir (14) comprennent ladite traverse avant (9) et ladite traverse arrière (10) ayant, au côté inférieur et intérieur, sur toute la direction longitudinale, des broches insérées (21) disposées régulièrement, dont la partie qui fait saillie de ladite traverse (9, 10), présente, en section transversale, une forme approximativement en demi-cercle, leur extrémité arrondie étant tournée vers l'axe transversal de symétrie du pochoir (14), et en ce que les barres rectangulaires (22) de pression présentent des trous situés sur leur longueur et le pochoir (14) présente une perforation (24) le long de ses bords, qui correspondent à l'agencement des broches (21) sur lesdites traverses (9, 10), et en ce que le pochoir (14) comporte des guides supplémentaires (25) à ses bords, sous la forme d'encoches de forme en U.
